Europäisches Patentamt

European Patent Office

Office européen des brevets

(19)

(11) Numéro de publication: **0 021 899**

**A1**

(12)

# DEMANDE DE BREVET EUROPEEN

(21) Numéro de dépôt: **80400772.2**

(22) Date de dépôt: **30.05.80**

(51) Int. Cl.³: **H 01 L 29/91**

(30) Priorité: **06.06.79 FR 7914442**

(43) Date de publication de la demande:
**07.01.81 Bulletin 81/1**

(84) Etats Contractants Désignés:
**DE GB IT NL**

(71) Demandeur: **"LE SILICIUM SEMICONDUCTEUR SSC"**
**45, rue de Monceau**
**F-75008 Paris(FR)**

(72) Inventeur: **Bacuvier, Pierre**
**"THOMSON-CSF" - SCPI 173, bld Haussmann**
**F-75360 Paris Cedex 08(FR)**

(74) Mandataire: **de Beaumont, Michel et al,**
**"THOMSON-CSF" SCPI 173, Bld Haussmann**
**F-75360 Paris Cedex 08(FR)**

(54) **Diode de Shockley et son procédé de fabrication.**

(57) La présente invention concerne une diode de Shockley et son procédé de fabrication.

Cette diode de Shockley comprend outre les couches habituelles (1, 2, 3 et 4), deux couches supplémentaires (11 et 12) de même type de conductivité que le substrat (1) mais à dopage plus élevé, le dopage du substrat étant maintenu à une valeur faible.

Application à la fabrication de diodes de Shockley de tension de retournement faible et nettement déterminée.

FIG.2A

EP 0 021 899 A1

Croydon Printing Company Ltd.

1

DIODE DE SHOCKLEY ET SON PROCEDE DE FABRICATION.

La présente invention concerne une diode de Shockley et son procédé de fabrication.

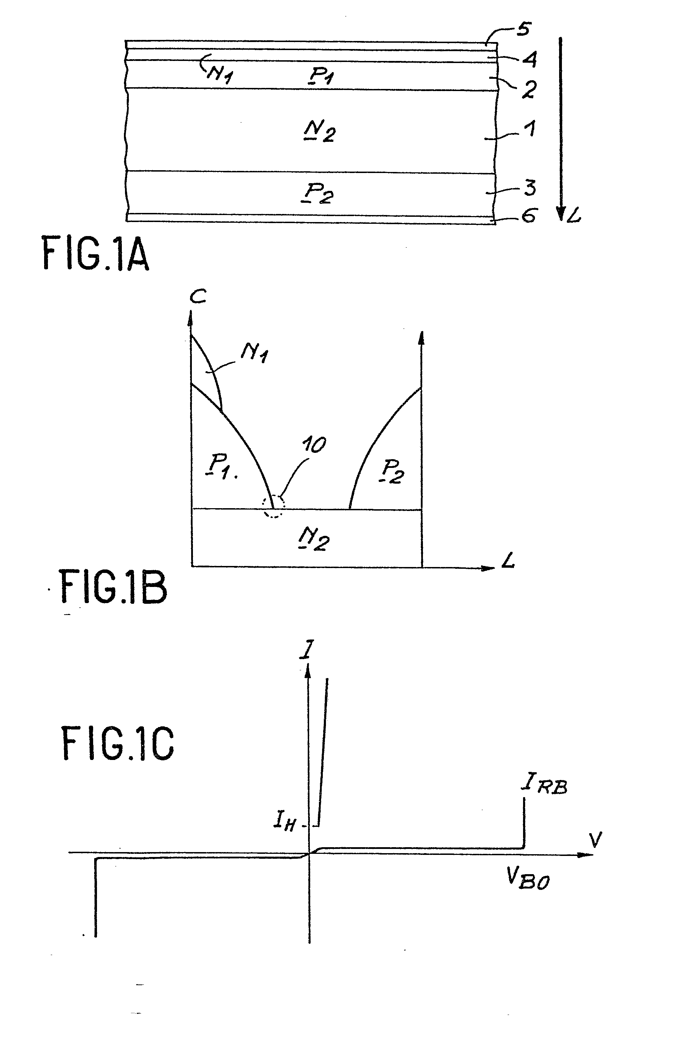

Une diode de Shockley unidirectionnelle, également appelée diode à quatre couches ou diode thyristor, est un dispositif bipolaire PNPN semblable à un thyristor dont seules seraient accessibles les bornes d'anode et de cathode à l'exclusion de la borne de gâchette. Une diode de Shockley est représentée schématiquement en figure 1A. Elle est formée à partir d'un substrat d'un premier type de conductivité qui sera considéré comme de type N dans la description suivante. Ce substrat est désigné par la référence 1. Il est entouré de couches 2 et 3 de type P également désignées par P1 et P2, respectivement ; la couche 2 ou couche supérieure est revêtue d'une couche 4 de type N également appelée couche N1. Des métallisations 5 et 6 sont prévues de part et d'autre du composant. De façon générale, les couches P1, P2 et N1 sont obtenues par diffusion bien que d'autres approches puissent être utilisées.

La figure 1B indique la concentration en atomes dopants en fonction de la distance à partir de la face supérieure du composant. On peut voir que la couche N1 est fortement dopée, et la couche N2, à savoir le substrat, est la plus faiblement dopée. La concentration superficielle $C_s$ au niveau de la couche N1 est de l'ordre de $10^{21}$ at./cm$^3$ et le substrat est nettement moins dopé, c'est-à-dire que sa concentration n'est pas supérieure à $10^{18}$ atomes par centimètre cube, cette dernière valeur étant choisie en fonction de la tenue en tension souhaitée pour le dispositif.

La figure 1C représente une caractéristique typique de diode de Shockley. Tant que la tension directe à ses bornes est inférieure à un certain seuil désigné par $V_{BO}$, pratiquement aucun courant ne traverse la diode qui se comporte comme un interrupteur ouvert. Par contre, quand la tension directe à ses bornes atteint et dépasse la valeur $V_{BO}$, le courant commence à croître dans la diode et il se produit un retournement brutal au-delà d'un courant $IR_B$ dit courant de retournement. La tension aux bornes chute alors brutalement et un courant important peut passer dans le dipôle. Ensuite, si le courant redescend, le point de fonctionnement reste sur cette partie de la caractéristique à fort courant et faible tension jusqu'à ce que le courant diminue en-dessous d'une valeur $I_H$ ou courant de maintien. Alors, la diode revient à son état de fonctionnement équivalent à un circuit ouvert et il faut un nouveau dépassement de la tension $V_{BO}$ pour que le dipôle redevienne conducteur.

La valeur de courant de retournement $I_{RB}$ est représentative de la sensibilité du dispositif à commuter. Plus la valeur de $I_{RB}$ est faible, plus le dispositif est dit sensible.

On cherche actuellement à fabriquer des diodes de Shockley pour lesquelles la tension $V_{BO}$ est clairement définie de façon à pouvoir servir de dispositif de sécurité. Notamment, un besoin se fait sentir pour des diodes de Shockley ayant une tension $V_{BO}$ d'une valeur fixe donnée comprise notamment dans la gamme de 20 à 200 volts (par exemple 60 volts $\pm$ 5 volts). De tels dispositifs peuvent servir notamment comme sécurité pour des lignes téléphoniques.

Lorsque l'épaisseur de couche N2 est suffisante, la détermination de la valeur $V_{BO}$ dépend essentiellement du niveau de dopage à l'intersection des zones P1 et N2, c'est-à-dire de la valeur de la concentration pour le point 10 indiqué en figure 1B. Ainsi, avec les diodes de l'art antérieur, pour modifier le niveau de concentration dans la zone désignée par la référence 10, il convient de jouer sur la concentration en dopant dans le substrat 1. On rappelle que la concentration en atomes dopants détermine la résistivité $\rho$.

3

On parlera donc tantôt de la concentration du substrat, tantôt de la résistivité $\rho_{N2}$ de celui-ci. Quand la concentration en dopant croît, la résistivité diminue et inversement. Ce procédé, qui ne consiste qu'à jouer sur la valeur de la résistivité du substrat présente deux inconvénients principaux.

D'une part, pour agir sur la résistivité du substrat, une action s'effectue au niveau du tirage des lingots de silicium ultérieurement découpés en plaquettes sur lesquelles sont formées les diodes. Or, dans la pratique, il s'avère que, quand on cherche à jouer sur la résistivité d'un lingot de silicium, au cours du tirage pour un lingot donné, il se présente une dispersion importante de la résistivité pour des plaquettes distinctes découpées à partir du même lingot, c'est-à-dire qu'il y a inhomogénéité de dopage. Egalement, il est clair qu'une telle action au niveau d'un lingot de silicium entraîne un préconditionnement a priori d'un très grand nombre de futures plaquettes et, si l'on veut avoir une gamme de fabrication relativement importante à niveaux de $V_{BO}$ distincts, ceci oblige à traiter un grand nombre de lingots et à disposer d'un stock de silicium important.

D'autre part, dans le cas où l'on cherche à obtenir une faible valeur de $V_{BO}$, il faut que le dopage du substrat ait un niveau élevé, c'est-à-dire que $\rho_{N2}$ soit faible. Ces valeurs faibles de résistivité conduisent à un abaissement de la durée de vie $\tau_{N2}$ des porteurs dans la zone N2. Or, la couche de substrat 1 (ou N2) est relativement épaisse pour des raisons mécaniques et il n'est pas facile de compenser l'abaissement de la durée de vie par l'utilisation de couches N2 très minces. Il en résulte que le gain du transistor P1N2P2 est faible et que l'on risque d'avoir de mauvais retournements, c'est-à-dire que, une fois que l'on atteint la tension $V_{BO}$, il faut

0021899

4.

que l'on ait un courant $I_{RB}$ relativement important passant dans la diode de Shockley pour qu'il y ait effectivement retournement. En d'autres termes, le dispositif risque d'avoir un fonctionnement en diode Zener jusqu'à un niveau élevé. Dans certains cas, il peut même être impossible de mettre le dispositif en état de conduction.

Un objet de la présente invention est de prévoir une nouvelle structure de diode de Shockley palliant les inconvénients de l'art antérieur.

Un autre objet de la présente invention est de prévoir un nouveau procédé d'obtention de diode de Shockley.

Un autre objet de la présente invention est de prévoir une diode de Shockley dont les caractéristiques soient réglables en cours de fabrication à partir de plaquettes obtenues à partir d'un même lingot de substrat.

Un autre objet de la présente invention est de prévoir une diode de Shockley dont les caractéristiques de tension de retournement ($V_{BO}$) soient réglables en cours de fabrication pratiquement indépendamment des caractéristiques de sensibilité (niveau de courant de retournement et valeur de courant de maintien $I_H$).

Un autre objet de la présente invention est de prévoir aussi bien des diodes de Shockley unidirectionnelles que des diodes de Shockley bidirectionnelles.

Pour atteindre ces objets ainsi que d'autres, la présente invention prévoit une diode de Shockley comprenant un substrat d'un premier type de conductivité pris en sandwich entre deux couches du deuxième type de conductivité, la couche supérieure étant recouverte d'une couche du premier type de conductivité, cette diode de Shockley comprenant en outre deux couches du premier type de conductivité de part et d'autre du substrat et de niveau de dopage plus élevé que celui-ci.

La présente invention prévoit également un procédé de fabrication de diode de Shockley à partir d'un substrat d'un premier type de conductivité à faible niveau de dopage comprenant les étapes suivantes :

- diffuser à partir d'au moins la face supérieure du substrat un dopant du premier type de conductivité,

- diffuser à partir des deux faces de la structure un dopant du deuxième type de conductivité, la pénétration de cette diffusion étant déterminée en fonction de la tension de retournement souhaitée, et

- diffuser à partir de la face supérieure de la structure un dopant du premier type de conductivité, ce dernier pouvant éventuellement être diffusé simultanément lors de l'opération précédente.

Ces objets, caractéristiques et avantages ainsi que d'autres de la présente invention seront exposés en détail dans la description suivante de modes de réalisation particuliers faite en relation avec les figures jointes parmi lesquelles :

- les figures 1A, 1B et 1C représentent respectivement une structure, un profil de concentration et une caractéristique tension-courant d'une diode Shockley unidirectionnelle de l'art antérieur ;

- les figures 2A, 2B et 2C représentent respectivement une structure, un profil de concentration et un détail agrandi de ce profil pour une diode de Shockley selon l'invention ;

- les figures 3A, 3B et 3C concernent une diode de Shockley bidirectionnelle.

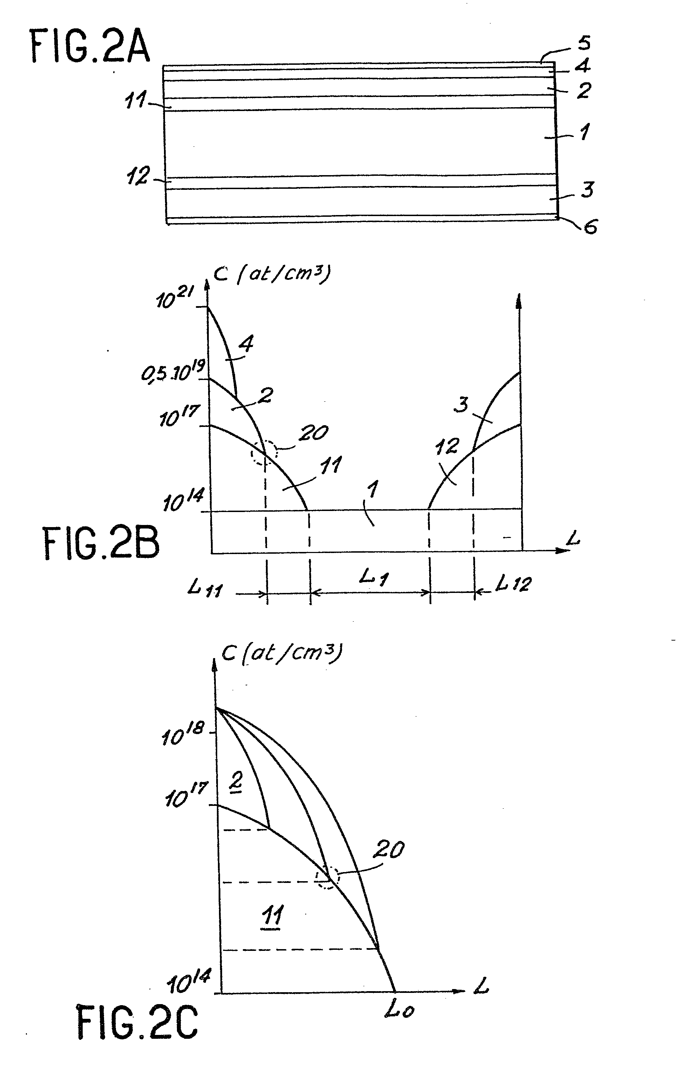

La figure 2A représente la structure de diode de Shockley selon la présente invention. Outre les

6

couches 1,2,3,4,5 et 6 déjà décrites en relation avec la figure 1A, la structure représentée comprend des couches supplémentaires 11 et 12 de part et d'autre du substrat N2. Ces couches 11 et 12 sont des couches de même type de conductivité que le substrat, c'est-à-dire de type N dans le cas représenté, mais de plus fort niveau de dopage.

La figure 2B illustre le profil de concentration dans le cas où les diverses couches sont formées par diffusion. Ces diverses couches sont désignées en figure 2B par les mêmes références qu'en figure 2A. Alors qu'en figure 1B, avec le dispositif classique la tension de retournement $V_{BO}$ était déterminé essentiellement par le niveau de dopage à l'interface entre la couche 2 et le substrat 1, il est maintenant déterminé essentiellement par le niveau de dopage à l'interface entre la couche 2 de type P et la couche supplémentaire 11 de type N dans la région désignée par la référence 20. Ainsi, pour un substrat donné et pour des couches diffusées 11 et 12 données, on pourra déplacer la concentration à l'interface dans la zone 20 en modifiant le profil de diffusion de la couche 2 pour que l'intersection entre la courbe de concentration de diffusion de la couche 2 et la courbe de concentration de diffusion de la couche 11 se situe plus ou moins profondément, c'est-à-dire que le point 20 se situe plus ou moins à droite sur la figure. Partant, la concentration à l'interface est modifiée. Par exemple, dans le cas où la concentration de la couche 11 varie entre $5.10^{17}$ atomes par $cm^3$ en surface et $10^{14}$ atomes par $cm^3$ à l'interface avec le substrat, la concentration pour la couche 2 du type P, à l'interface entre les couches 2 et 11 peut varier sensiblement entre cette valeur nominale de $10^{14}$ et une valeur maximale sensiblement de l'ordre de $10^{17}$.

La concentration superficielle de la couche 2 peut être de l'ordre de $0,5 \times 10^{19}$. On notera que le profil de diffusion de la couche 3 varie en même temps que le profil de diffusion de la couche 2.

La figure 2C représente de façon plus détaillée l'intersection des courbes correspondant aux profils de diffusion des couches 2 et 11 quand le profil de diffusion de la couche 2 se modifie et qu'une profondeur de diffusion plus ou moins grande est atteinte, ce qui correspond à des variations de concentration à l'interface et à des variations correspondantes de la tension de retournement $V_{BO}$.

En ce qui concerne la sensibilité de retournement du dispositif selon l'invention, elle est assurément meilleure que celle du dispositif de l'art antérieur du fait que la partie de couche de type N entre les zones $P_1$ et $P_2$ comprend essentiellement l'épaisseur $L_1$ du substrat 1 plus les épaisseurs $L_{11}$ et $L_{12}$ correspondant aux couches 11 et 12 de même type de conductivité que le substrat mais de plus fort niveau de dopage. On a vu précédemment qu'il y avait intérêt à ce que les couches de transition à niveau de dopage élevé, c'est-à-dire dans lesquelles la durée de vie des porteurs est faible, soient aussi minces que possible. En effet, le gain global du transistor interne dépend des contributions respectives des couches 11, 1 et 12 et, bien que l'épaisseur $L_1$ soit assez importante, cette zone ne contribue pratiquement pas à l'affaiblissement du gain puisqu'une durée de vie élevée peut y être maintenue en raison de sa résistivité élevée. En considérant la figure 2B, il y aurait donc intérêt à ce que les épaisseurs $L_{11}$ et $L_{12}$ soient aussi faibles que possible pour améliorer cette caractéristique de retournement, ce qui peut s'obtenir en réduisant l'épaisseur Lo (voir figure 2C). Néanmoins, il ne faut pas réduire cette épaisseur Lo à une valeur trop faible, car alors il deviendrait

8

difficile d'ajuster le réglage du point 20 d'intersection entre les profils de concentration des couches
2 et 11.

Dans la pratique, le procédé selon la présente
invention consiste à partir d'un substrat de premier
type de conductivité, à effectuer une diffusion de
part et d'autre de ce substrat d'un dopant de même
type de conductivité puis à effectuer une diffusion
de part et d'autre de la plaquette d'un dopant du
deuxième type de conductivité (P). Cette diffusion
comprend d'abord une étape de pré-dépôt puis une étape
de redistribution pour ajuster la pénétration, c'est-
à-dire augmenter éventuellement la tension de retournement de la diode de Shockley que l'on cherche à
obtenir. On pourra effectuer une vérification en cours
de redistribution pour déterminer la durée exacte de
l'étape de redistribution ou bien procéder par étalonnage initial pour prédéterminer a priori des durées de redistribution en fonction des tensions de
retournement que l'on cherche à atteindre. Ainsi,
à partir d'une même plaquette substrat ayant subi
des diffusions de type N sur ses deux faces, puis
un pré-dépôt de type P, on pourra obtenir des diodes
de Shockley à tensions de retournement distinctes en
fonction de la durée de la redistribution. Ceci assure
une grande souplesse de fabrication. Bien entendu,
il convient de prévoir les étapes de formation de la
couche 4 de type N et des métallisations 5 et 6.

On a décrit précédemment des diodes de Shockley
à fonctionnement symétrique (en entend par symétrique
le fait que la tension de retournement est la même
en direct et en inverse, mais bien entendu en inverse
on obtient une caractéristique de type Zener et non
une caractéristique de type Shockley). Dans les cas
où la tension de retournement inverse n'a pas à avoir
une valeur précise, il est inutile de prévoir la
couche 12.

Pour désensibiliser la diode de Shockley selon la présente invention, on pourra procéder de façon classique en réduisant de façon contrôlée la durée de vie des porteurs, par exemple par diffusion d'or, par irradiation électronique, en utilisant une distribution de trous de courts circuits ou en modulant la résistance lamellaire de la couche P1 (c'est-à-dire en modifiant la concentration superficielle de cette couche). Ainsi dans une diode de Shockley, la sensibilité peut être déterminée pratiquement indépendamment de l'aspect associé à l'obtention de la tension de retournement visée.

A titre d'exemple quantitatif, en partant d'une plaquette d'une épaisseur de 200 à 300 microns de type N avec une concentration de l'ordre de $10^{14}$ atomes par $cm^3$, on a fabriqué des diodes de Shockley selon la présente invention en prévoyant des couches 11 et 12 d'une épaisseur de l'ordre de 50 microns à concentration superficielle de l'ordre de $5 \times 10^{17}$ (phosphore) puis des couches 2 et 3 de type P dont la profondeur de pénétration a été modifiée entre 20 et 40 microns avec une concentration superficielle de l'ordre de $5 \times 10^{18}$ atomes par $cm^3$ de gallium ou de bore. On a alors obtenu des tensions de retournement variant entre 50 et 200 volts. Ensuite, une couche 4 de type N a été réalisée sur la face supérieure par diffusion d'arsenic ou de phosphore avec une concentration superficielle de l'ordre de $10^{21}$ atomes par $cm^3$ et une profondeur de pénétration de 10 à 15 microns.

On s'est également aperçu qu'outre le fait que l'on pouvait obtenir à partir d'un même substrat et de mêmes premières étapes de diffusion, une tension de retournement choisie dans une plage importante, un autre avantage de la présente invention était que les divers phénomènes et caractéristiques de fonctionnement se sont avérés être très répétitifs d'une

10

expérience à l'autre et que la dispersion de fabrication était faible.

La présente invention n'est pas limitée aux modes de réalisation qui ont été explicitement décrits mais elle en englobe les variantes et généralisations incluses dans la formulation des revendications ci-après.

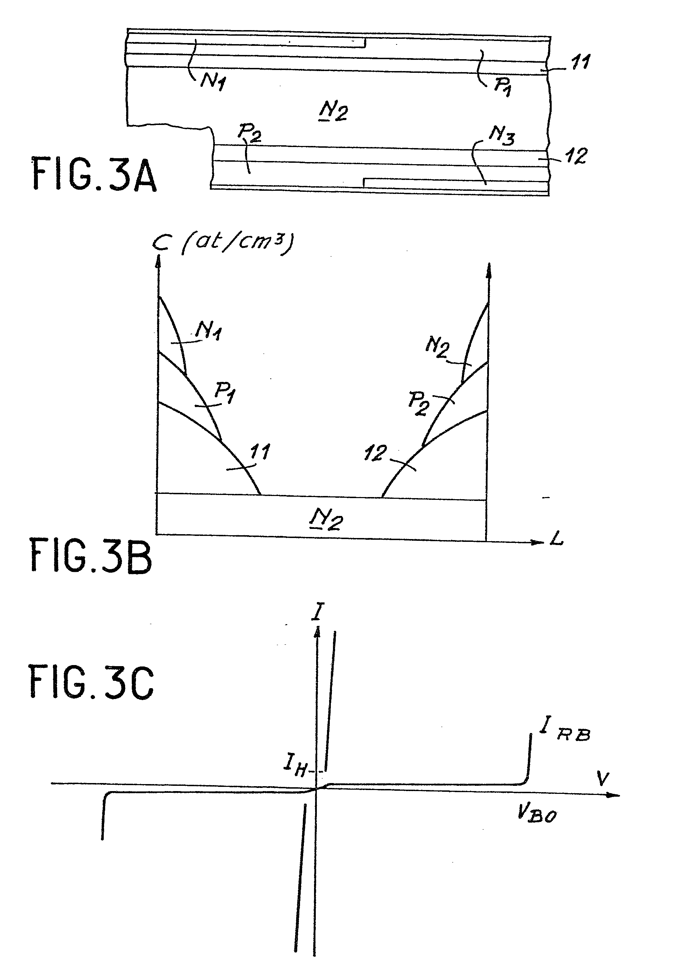

En particulier, elle concerne également une diode de Shockley bidirectionnelle constituée par l'intégration monolithique en opposition de deux structures individuellement identiques à celle précédemment décrite (figures 3A et 3B). Le dispositif ainsi obtenu présentera alors un retournement en polarisation directe et en polarisation inverse (figure 3C).

D'autre part, pour certaines applications, la diode de Shockley doit revenir dans son état de blocage dès que la tension à ses bornes chute, mais alors que la tension a quand même une valeur non négligeable, par exemple 48 volts. Pour ce faire, une diode Zener ayant une tension de seuil de, par exemple, 70 volts est disposée en série avec la diode de Shockley. Les deux diodes peuvent être disposées dans un même boîtier. Ce montage peut notamment être utile lors d'une application à la protection de circuits téléphoniques.

REVENDICATIONS

1. Diode de Shockley comprenant un substrat d'un premier type de conductivité pris en sandwich entre deux couches d'un deuxième type de conductivité, la couche supérieure étant recouverte d'une couche du premier type de conductivité, caractérisée en ce qu' elle comprend en outre deux couches du premier type de conductivité de part et d'autre du substrat et à niveau de dopage plus élevé que celui-ci.

2. Diode de Shockley selon la revendication 1, caractérisée en ce que le substrat est de type N.

3. Diode de Shockley selon l'une des revendications 1 ou 2, caractérisée en ce que la concentration d'atomes dopants dans le substrat est comprise entre $10^{13}$ et $10^{15}$ atomes par $cm^3$.

4. Procédé de fabrication d'une diode de Shockley à partir d'un substrat d'un premier type de conductivité à faible niveau de dopage, caractérisé en ce qu'il comprend les étapes suivantes :

- diffuser à partir d'au moins la face supérieure du substrat un dopant du premier type de conductivité ;

- diffuser à partir des deux faces de la structure un dopant du deuxième type de conductivité, la durée de cette diffusion étant déterminée en fonction de la tension de retournement souhaitée ; et

- diffuser à partir de la face supérieure de la structure un dopant du premier type de conductivité.

5. Procédé de fabrication d'une diode de Shockley suivant la revendication 4, caractérisé en ce que la concentration d'atomes dopants dans le substrat est de l'ordre de $10^{13}$ à $10^{15}$ atomes par $cm^3$.

6. Procédé selon la revendication 5, caractérisé en ce que les diffusions du premier type de conductivité effectuées en premier lieu dans le

12

substrat ont une concentration superficielle de l'ordre de $10^{17}$ à $10^{18}$ atomes par $cm^3$.

7. Procédé de fabrication d'une diode de Shockley selon la revendication 4, caractérisé en ce que la diffusion d'un deuxième type de conductivité de durée variable et prédéterminée correspond à une concentration superficielle de l'ordre de $5 \times 10^{18}$ atomes par $cm^3$.

FIG.1A

FIG.1B

FIG.1C

FIG.2A

FIG.2B

FIG.2C

FIG.3A

FIG.3B

FIG.3C

0021899

**Office européen
des brevets**

## RAPPORT DE RECHERCHE EUROPEENNE

Numéro de la demande

EP 80 40 0772

| DOCUMENTS CONSIDERES COMME PERTINENTS | | | CLASSEMENT DE LA DEMANDE (Int. Cl. 3) |
|---|---|---|---|
| Catégorie | Citation du document avec indication, en cas de besoin, des parties pertinentes | Revendica-tion concernée | |
| | US - A - 3 176 147 (IBM) <br><br> * Colonne 1, lignes 31-34; colonne 4, lignes 29-43; figure 2 * <br><br> ---- | 1 | H 01 L 29/91 |

**DOMAINES TECHNIQUES RECHERCHES (Int. Cl. 3)**

H 01 L 29/91

**CATEGORIE DES DOCUMENTS CITES**

X: particulièrement pertinent
A: arrière-plan technologique
O: divulgation non-écrite
P: document intercalaire
T: théorie ou principe à la base de l'invention
E: demande faisant interférence
D: document cité dans la demande
L: document cité pour d'autres raisons

&: membre de la même famille, document correspondant

Le présent rapport de recherche a été établi pour toutes les revendications

| Lieu de la recherche | Date d'achèvement de la recherche | Examinateur |
|---|---|---|
| La Haye | 12-09-1980 | PELSERS |

OEB Form 1503.1  06.78